# EUROPEAN PATENT SPECIFICATION

(11) **EP 2 657 623 B1**
(45) Date of publication and mention of the grant of the patent: **07.09.2016**
(21) Application number: 13159801.3
(22) Date of filing: 18.03.2013
(51) Int. Cl.: F24J 2/38, F24J 2/54

(54) **Automatic solar tracking adjustment/control apparatus of solar generation system**
Automatische Anpassungs-/Steuervorrichtung zur Sonnennachführung eines Solarstromerzeugungssystems
Appareil d'ajustement/contrôle de suivi solaire automatique pour système de génération solaire

(30) Priority: 23.04.2012 TW 101114440; 02.11.2012 TW 101140712
(43) Date of publication of application: 30.10.2013
(73) Proprietor: BIG SUN Energy Technology Incorporation, 30353 Hsinchu County (TW); Luo, Chia Ching, 30353 Hsinchu County (TW)
(72) Inventor: Luo, Chia Ching, 30353 Hsinchu County (TW)
(74) Representative: Chaillot, Geneviève

(56) References cited:
- JP-A- 2010 010 543
- US-A- 4 762 298
- US-A1- 2008 011 288
- US-A1- 2011 114 079
- US-A1- 2011 208 326

## Description

### BACKGROUND OF THE INVENTION

### 1. Field of the Invention

The present invention relates generally to an automatic solar tracking adjustment/control apparatus of solar generation system, and more particularly to a solar tracking adjustment/control apparatus, which can drive the solar generation module and detect the tilting state of the solar generation module so as to automatically precisely adjust the tilting direction and inclination angle of the solar generation module in accordance with preset parameters. Accordingly, the solar generation module can always face the sun to achieve best power generation efficiency.

### 2. Description of the Related Art

A conventional simple-type solar generation apparatus (solar panel) is generally disposed in a fixed position and tilted at a fixed inclination angle for receiving sunshine. Such simple-type solar generation apparatus has a simplified structure and is easy to install so that the installation cost and the successive maintenance fee are lower. However, in practice, the position of the sun changes with time. Therefore, the solar generation apparatus (solar panel) disposed in the fixed position and tilted at the fixed inclination angle cannot always face the sun, that is, the projection direction of the sunshine can be hardly kept normal to the solar panel. Accordingly, it is hard for the solar generation apparatus (solar panel) to have an optimal sunshine effect. As a result, the power generation efficiency of such solar generation apparatus is poor.

To solve the above problem, an improved solar generation apparatus (solar panel) adjustable in inclination angle has been disclosed and applied in this field. In such solar generation apparatus, the solar panel is disposed on a secure support via a pivotal rotational joint. A drive mechanism is used to drive the solar panel to pivotally rotate relative to the support. Accordingly, the solar panel can be tilted by different inclination angles with the change of the position of the sun according to preset parameters. Therefore, the direction of the sunshine can be kept normal to the solar panel so that the power generation efficiency is enhanced. However, the drive mechanism of the above solar panel is generally driven by a motor as a power source. The motor outputs power and transmits the power to the drive mechanism via a chain or a belt. During the rotation of the solar panel, the chain or belt will inevitably slightly slip to cause error in precision. As a result, the solar panel can be hardly pivotally rotated and tilted in an expected direction and inclination angle. Therefore, it is tried by the applicant to provide an automatic solar tracking adjustment/control apparatus of solar generation system, which can always automatically detect the tilting direction and inclination angle of the solar panel and compare these parameters with the preset reference parameters to adjust the tilting direction and inclination angle of the solar panel. Therefore, the solar panel can be precisely pivotally rotated and tilted in accordance with the preset reference parameters. Accordingly, the solar panel can have an optimal sunshine effect to achieve best power generation efficiency.

US 2008/011288 A1 and US 2011/208326 A1 disclose an automatic solar tracking adjustment/control apparatus of solar generation system as defined in the preamble of claim 1.

### SUMMARY OF THE INVENTION

It is therefore a primary object of the present invention to provide an automatic solar tracking adjustment/control apparatus of solar generation system. The solar tracking adjustment/control apparatus includes an accelerometer for detecting the tilting direction and inclination angle of the solar generation module to generate correction information so as to control the pivotal rotation of the solar generation module. Accordingly, the solar generation module can be always precisely tilted in a correct direction and angle in accordance with the preset solar tracking parameters.

It is a further object of the present invention to provide the above automatic solar tracking adjustment/control apparatus of solar generation system in which the drive assemblies will not slip or idle during operation. Therefore, the rotation of the solar generation module can be more precisely controlled.

To achieve the above and other objects, the automatic solar tracking adjustment/control apparatus of solar generation system of the present invention is as defined in claim 1.

In the above automatic solar tracking adjustment/control apparatus, the detection/correction module at least includes an accelerometer.

In the above automatic solar tracking adjustment/control apparatus, the control unit is disposed in the detection/correction module.

In the above automatic solar tracking adjustment/control apparatus, the support assembly at least has a support column. The support seat is disposed at one end of the support column.

In the above automatic solar tracking adjustment/control apparatus, the power source is a motor and the connection member is a steel cable and the drive member is a drive wheel connected to the steel cable.

In the above automatic solar tracking adjustment/control apparatus, each drive assembly further includes at least one idling member and the connection member passes through an edge of the idling member and is reversely wound.

In the above automatic solar tracking adjustment/control apparatus, each connection member is serially connected with at least one elastic member.

In the above automatic solar tracking adjustment/control apparatus, the carrier platform is polygonal and two ends of the connection member are respectively connected to two opposite corners of the carrier platform.

In the above automatic solar tracking adjustment/control apparatus, each of the connection members is connected to an elastic adjustment assembly.

In the above automatic solar tracking adjustment/control apparatus, the elastic adjustment assembly includes at least one elastic member fitted on the connection member.

In the above automatic solar tracking adjustment/control apparatus, a first end of the elastic member is connected to an external fixed article, while a second end of the elastic member is provided with a fitting member connected to a middle section of the connection member.

In the above automatic solar tracking adjustment/control apparatus, the fitting member is a pulley.

In the above automatic solar tracking adjustment/control apparatus, the two drive sections are two annular grooves disposed on the drive wheel. The two connection members are respectively wound on the annular grooves in reverse directions.

In the above automatic solar tracking adjustment/control apparatus, the carrier platform is polygonal and two ends of the connection member are respectively connected to two opposite corner sections of the carrier platform.

In the above automatic solar tracking adjustment/control apparatus, the pivotal rotational assembly includes a pivot seat, a first shaft rod and a second shaft rod. The first and second shaft rods pass through the pivot seat and intersect each other. Two ends of the first shaft rod are disposed on the support seat, while two ends of the second shaft rod are disposed on the carrier platform.

In the above automatic solar tracking adjustment/control apparatus, the two ends of the first shaft rod are pivotally connected to the support seat via bearings and the two ends of the second shaft rod are connected to the carrier platform via bearings.

The present invention can be best understood through the following description and accompanying drawings, wherein:

### BRIEF DESCRIPTION OF THE DRAWINGS

Fig. 1 is a perspective view of an embodiment of an automatic solar tracking adjustment/control apparatus not forming part of the claimed invention;
Fig. 2 is an enlarged view of the pivot seat and the relevant sections of the embodiment of Fig. 1;
Fig. 3 is a perspective view showing the operation of the embodiment of Fig. 1 in one state;
Fig. 4 is a perspective view showing the operation of the embodiment of Fig. 1 in another state;
Fig. 5 is a perspective view of a first embodiment of the present invention;
Fig. 6 is an enlarged view of the first and second drive assemblies and the relevant sections of the first embodiment of the present invention;
Fig. 7 is a side view of the first embodiment of the present invention, showing the operation thereof; and
Fig. 8 is a view of the first and second drive assemblies and the relevant sections of a second embodiment of the present invention.

### DETAILED DESCRIPTION OF THE PREFERRED EMBODIMENTS

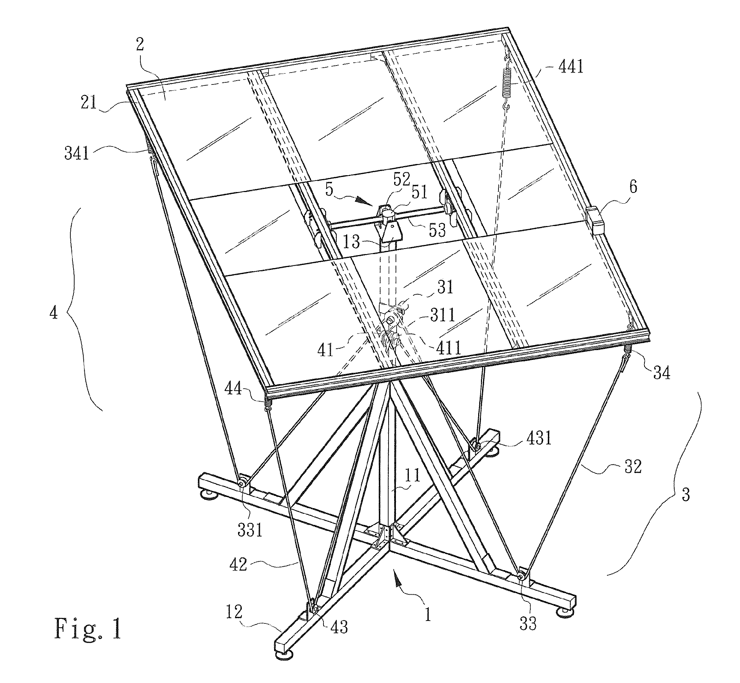

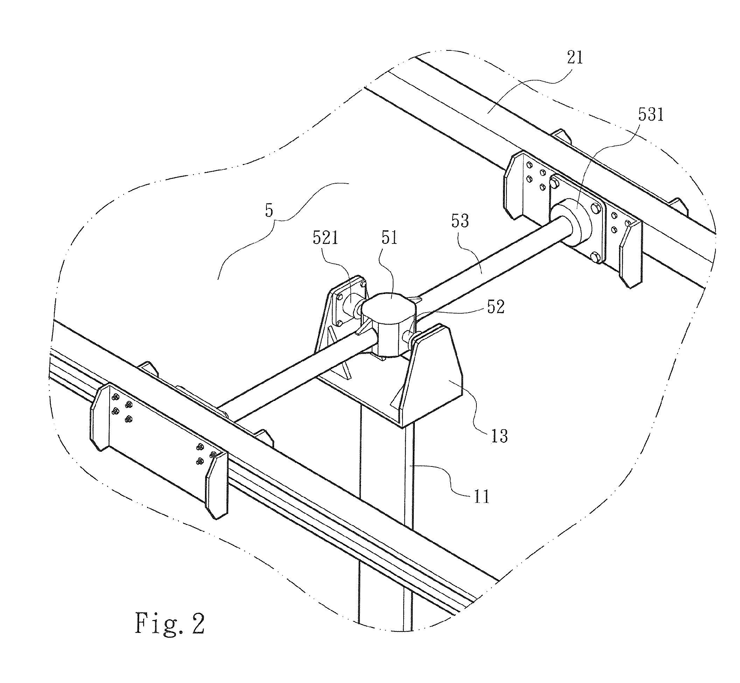

Please refer to Figs. 1 and 2. According to this embodiment, the automatic solar tracking adjustment/control apparatus of the solar generation system not forming part of the present invention includes a support assembly 1, a solar generation module 2, at least one drive assembly (a first drive assembly 3 and a second drive assembly 4 as shown in Fig. 1) for driving the solar generation module 2, a pivotal rotational assembly 5 and a detection/correction module 6. The support assembly 1 has a support column 11 and a base seat 12 outward extending from one end of the support column 11 for securely supporting the solar generation module 2 on the ground or a preset plane face. A support seat 13 is disposed at the other end of the support column 11, which end is distal from the base seat 12. A middle section of the support seat 13 is recessed.

The pivotal rotational assembly 5 is composed of a pivot seat 51, a first shaft rod 52 and a second shaft rod 53. The first and second shaft rods 52, 53 pass through the pivot seat 51 and intersect each other. The first shaft rod 52 is fixed on the pivot seat 51. Two ends of the first shaft rod 52 are pivotally disposed on the support seat 13 via two bearings 521. (In practice, alternatively, the two ends of the first shaft rod 52 can be fixed on the support seat 13 and the pivot seat 51 is pivotally connected on the middle section of the first shaft rod 52). Accordingly, the pivot seat 51 can be one-dimensionally pivotally rotated around the first shaft rod 52 relative to the support seat 13. The second shaft rod 53 is also fixed on the pivot seat 51. Two ends of the second shaft rod 53 are pivotally disposed on a carrier platform 21 via two bearings 531. (In practice, alternatively, the two ends of the second shaft rod 53 can be fixed on the carrier platform 21 and the pivot seat 51 is pivotally connected on the middle section of the second shaft rod 53). Accordingly, the carrier platform 21 can be two-dimensionally pivotally rotated around the second shaft rod 53 relative to the support seat 13.

The solar generation module 2 is disposed on the carrier platform 21 for receiving solar energy to generate electrical power.

The first drive assembly 3 and the second drive assembly 4 are disposed between the support assembly 1 and the carrier platform 21. In this embodiment, the first drive assembly 3 at least includes a first power source 31, (which can be a motor) and a connection member 32, (which can be a steel cable) . The first power source 31 (motor) is drivingly connected to the connection member 32 (steel cable) via a first drive member 311, (which can be a drive wheel). Two ends of the connection member 32 (steel cable) are connected to two opposite corner sections of the carrier platform 21. In this embodiment, the carrier platform 21 is polygonal (quadrangular) and the power source 31 is disposed at the middle of the support column 11. In addition, two idling members 33, 331, (which can be idlers) are disposed on the base seat 12 of the support assembly 1. The connection member 32 (steel cable) passes through the two idling members 33, 331 and is wound in the form of W. Furthermore, two ends of the connection member 32 (steel cable) are respectively serially connected to two elastic members 34, 341 and then connected to the opposite corner sections of the carrier platform 21.

The second drive assembly 4 at least includes a second power source 41, (which can be a motor) and a connection member 42, (which can be a steel cable) . The second power source 41 (motor) is drivingly connected to the connection member 42 (steel cable) via a second drive member 411, (which can be a drive wheel). Two ends of the connection member 42 (steel cable) are connected to two other opposite corner sections of the carrier platform 21. In this embodiment, the carrier platform 21 is polygonal (quadrangular) and the power source 41 is disposed at the middle of the support column 11. In addition, two idling members 43, 431, (which can be idlers) are disposed on the base seat 12 of the support assembly 1. The connection member 42 (steel cable) passes through the two idling members 43, 431 and is wound in the form of W. Furthermore, two ends of the connection member 42 (steel cable) are respectively serially connected to two elastic members 44, 441 and then connected to the other opposite corner sections of the carrier platform 21.

The detection/correction module 6 is disposed on the carrier platform 21. The detection/correction module 6 at least has an accelerometer and a control unit inside the detection/correction module 6. The accelerometer serves to detect various actual parameters including position, direction and inclination angle and transmit the actual parameters to the control unit. The control unit stores various preset reference parameters for comparing the actual parameters with the reference parameters. According to the comparison result, the control unit can modify the output of the power sources 31, 41.

In the above structure, in practice, the control unit can be alternatively disposed outside the detection/correction module 6, (for example, on the base seat 12 of the support assembly 1). In addition, the control unit can be received in a container as necessary.

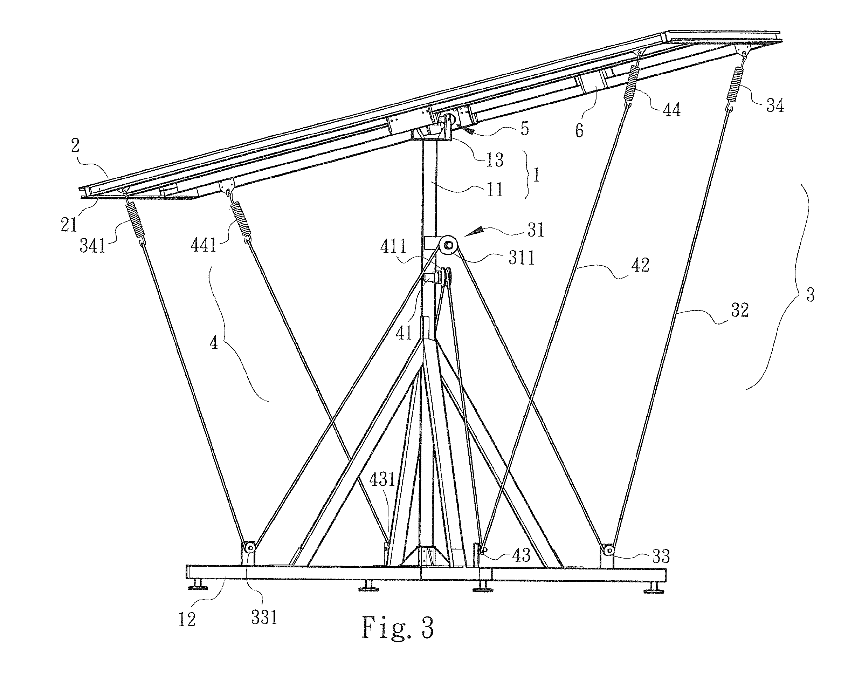

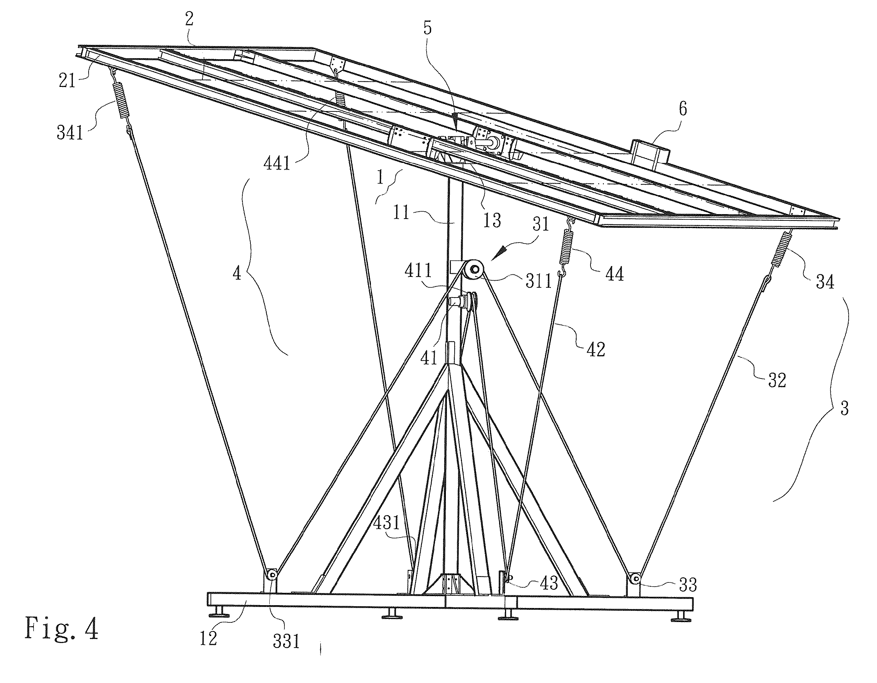

Please refer to Figs. 3 and 4. In operation of this embodiment, according to the various parameters stored in the control unit of the detection/correction module 6, the control unit drives the first and second power sources 31, 41 (motors) of the first and second drive assemblies 3, 4 to operate. At this time, via the first and second drive members 311, 411 (drive wheels), the first and second power sources 31, 41 (motors) respectively drive the connection members 32, 42 (steel cables) so as to drive the carrier platform 21 to pivotally rotate and tilt around the pivotal rotational assembly in a preset direction.

During the pivotal rotation and tilting of the carrier platform 21, the accelerometer in the detection/correction module 6 is synchronously tilted. At this time, the accelerometer can detect the various actual parameters of the carrier platform 21, including tilting direction and inclination angle and transmit the actual parameters to the control unit. The control unit compares the actual parameters with the preset reference parameters stored in the control unit. Then, according to the comparison result, the control unit modifies the output of the power sources 31, 41 so that the direction and inclination angle of the carrier platform 21 can conform to the set parameters stored in the control unit. Accordingly, the solar generation module 2 on the carrier platform 21 can be directed in a preset direction and tilted by a preset inclination angle to always face the sun so as to achieve an optimal sunshine effect and best power generation efficiency.

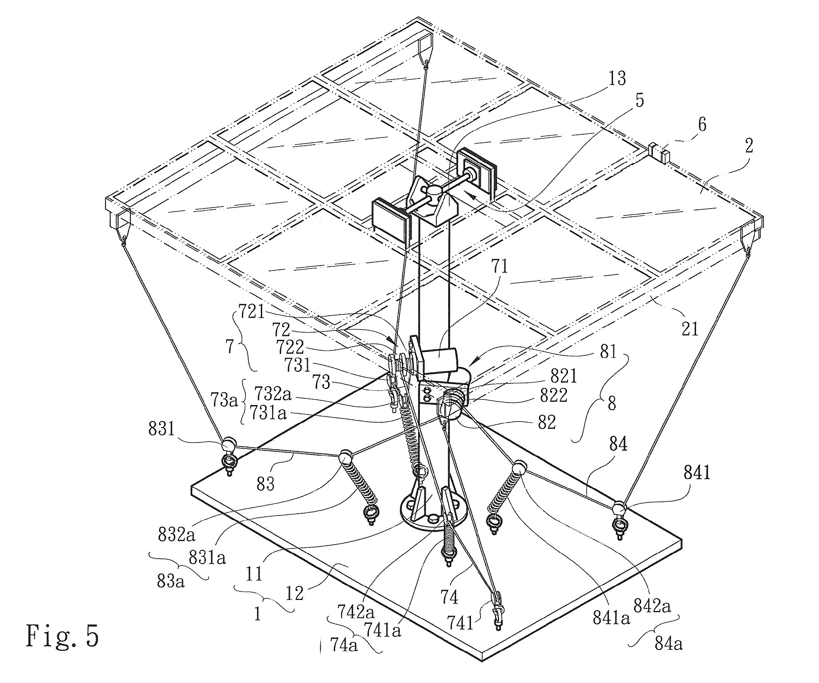

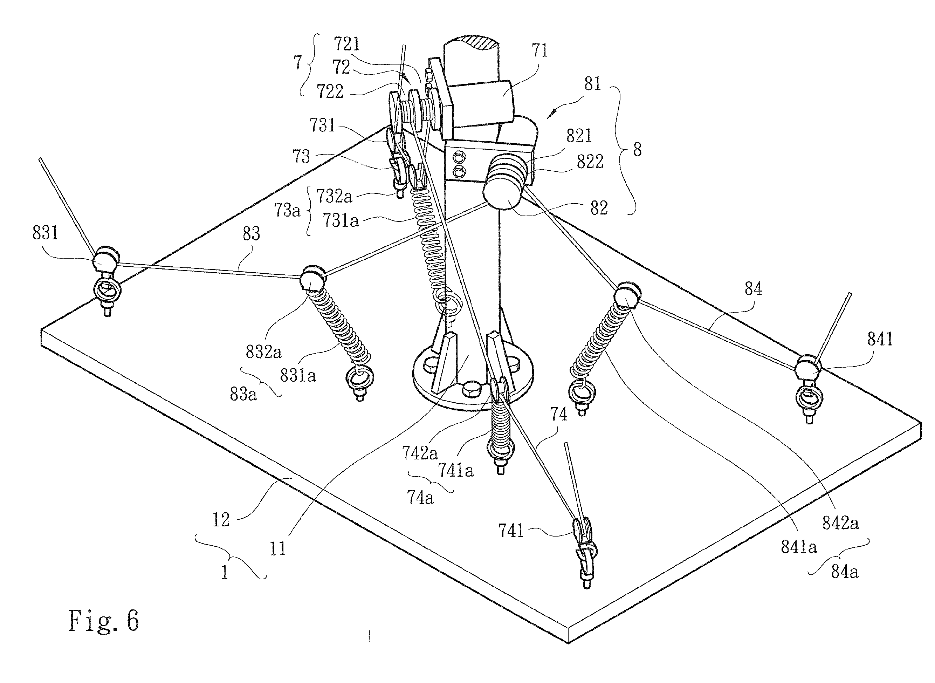

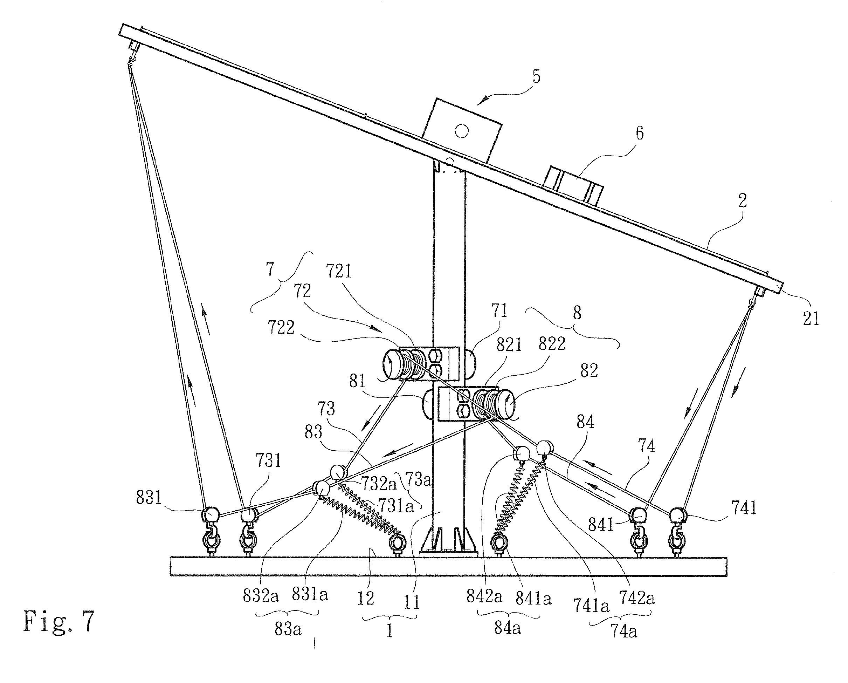

Please now refer to Figs. 5 to 7. According to a first embodiment, the automatic solar tracking adjustment/control apparatus of the solar generation system of the present invention includes a first drive assembly 7, a second drive assembly 8, a support assembly 1, a solar generation module 2, a pivotal rotational assembly 5 and a detection/correction module 6 as in the above embodiment. The first and second drive assemblies 7, 8 are respectively composed of a first power source 71 and a second power source 81, a first drive member 72 and a second drive member 82 drivable by the first and second power sources 71, 81 and multiple connection members 73, 74, 83, 84. A first drive section 721 and a second drive section 722 and a third drive section 821 and a fourth drive section 822 are respectively disposed on the first and second drive members 72, 82. The first and second drive sections 721, 722 are synchronously operable and the third drive section 821 and the fourth drive section 822 are also synchronously operable. In this embodiment, the first and second power source 71, 81 are motors and the first and second drive members 72, 82 are drive wheels disposed on output shafts of the motors. The first and second drive sections 721, 722 are two adjacent annular grooves disposed on the first drive member 72 (drive wheel). The two connection members 73, 74 are two steel cables. First ends of the two steel cables 73, 74 are respectively wound on the first and second drive sections 721, 722 (annular grooves) in reverse directions. The two connection members 83, 84 are two steel cables. First ends of the two steel cables 83, 84 are respectively wound on the third and fourth drive sections 821, 822 (annular grooves) in reverse directions. Middle sections of the connection members 73, 74, 83, 84 are first respectively conducted through idling members 731, 741, 831, 841, (which can be pulleys located on the base seat 12). Then second ends of the connection members 73, 74, 83, 84 are respectively connected to opposite corner sections of the carrier platform 21 corresponding to two lateral sides of the support assembly 1. In practice, the middle sections of the connection members 73, 74, 83, 84 can be further respectively conducted through elastic adjustment assemblies 73a, 74a, 83a, 84a. The elastic adjustment assemblies 73a, 74a, 83a, 84a serve to apply elastic pull force to the middle sections of the connection members 73, 74, 83, 84 so as to tension the connection members 73, 74, 83, 84 to a certain extent.

In the first embodiment of the present invention, the elastic adjustment assemblies 73a, 74a, 83a, 84a have identical structures. Each of the elastic adjustment assemblies includes an elastic member 731a, 741a, 831a, 841a, (which can be a spring) . A fitting section 732a, 742a, 832a, 842a, (which can be a pulley), is disposed at a first end of the elastic member 731a, 741a, 831a, 841a. The connection cable 73, 74, 83, 84 can be conducted through the fitting section 732a, 742a, 832a, 842a. A second end of the elastic member 731a, 741a, 831a, 841a is connected to the base seat 12. The elastic member 731a, 741a, 831a, 841a serves to elastically pull the connection cable 73, 74, 83, 84 to keep the connection cable in a properly tensioned state.

In operation, the power source 71 of the link assembly 7 drives the first drive member 72 to rotate. As aforesaid, the two connection members 73, 74 are respectively wound on the first and second drive sections 721, 722 (annular grooves). Therefore, in the case that the first drive section 721 forward drives the connection member 73 to wind up the same, then the second drive section 722 simultaneously unwinds the connection members 74 . Accordingly, the two connection members 73, 74 are synchronously extended in the same direction. Similarly, in the case that the first drive section 721 backward unwinds the connection member 73, then the second drive section 722 forward winds up the connection member 74. Accordingly, the first drive member 72 can drive the two connection members 73, 74 to extend in the same direction. Moreover, the two connection members 73, 74 are prevented from slipping on the first drive member 72 during rotation. Therefore, it is ensured that the operation is accurately performed. The link assembly 8 is operated in the same manner. Accordingly, the solar power generation module 2 (the carrier platform 21) can be stably tilted in a predetermined direction.

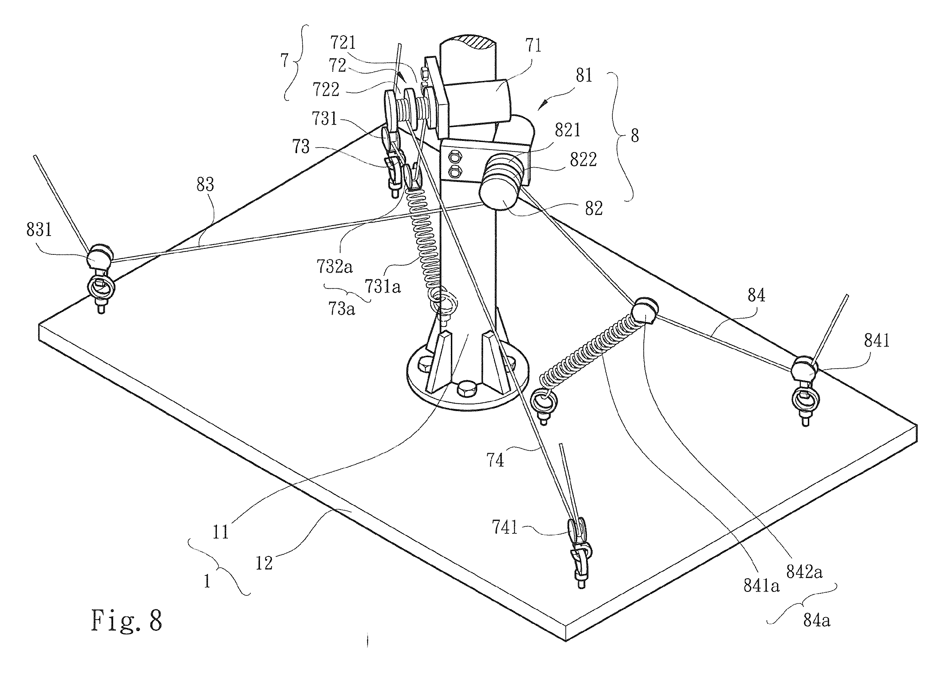

Please now refer to Fig. 8, which shows a second embodiment of the present invention. The third embodiment is substantially identical to the first embodiment in structure. In the first embodiment, the extending direction of the connection members 73, 74 intersects the extending direction of the connection cables 83, 84. (It is shown in the drawings that the connection cables 74, 83 intersect each other, while the connection cables 73, 84 do not intersect each other). The second embodiment is simply different from the first embodiment in that the intersecting connection cables 74, 83 are not provided with any elastic adjustment assembly so as to avoid touch or interference of the intersecting connection cables 74, 83 during operation due to deflection. However, the middle sections of the connection cables 73, 84 that do not intersect each other are still conducted through two elastic adjustment assemblies 73a, 84a identical to those of the first embodiment. The other parts of the second embodiment are identical to those of the first embodiment.

In conclusion, the automatic solar tracking adjustment/control apparatus of the solar generation system of the present invention can detect the tilting state of the solar generation module to automatically adjust the solar generation module to a correct inclination angle and correct direction according to the set parameters.

The above embodiments are only used to illustrate the present invention, not intended to limit the scope thereof. Many modifications of the above embodiments can be made without departing from the spirit of the present invention.
same manner. Accordingly, the solar power generation module 2 (the carrier platform 21) can be stably tilted in a predetermined direction.

Please now refer to Fig. 8, which shows a third embodiment of the present invention. The third embodiment is substantially identical to the second embodiment in structure. In the second embodiment, the extending direction of the connection members 73, 74 intersects the extending direction of the connection cables 83, 84. (It is shown in the drawings that the connection cables 74, 83 intersect each other, while the connection cables 73, 84 do not intersect each other) . The third embodiment is simply different from the second embodiment in that the intersecting connection cables 74, 83 are not provided with any elastic adjustment assembly so as to avoid touch or interference of the intersecting connection cables 74, 83 during operation due to deflection. However, the middle sections of the connection cables 73, 84 that do not intersect each other are still conducted through two elastic adjustment assemblies 73a, 84a identical to those of the second embodiment. The other parts of the third embodiment are identical to those of the second embodiment.

In conclusion, the automatic solar tracking adjustment/control apparatus of the solar generation system of the present invention can detect the tilting state of the solar generation module to automatically adjust the solar generation module to a correct inclination angle and correct direction according to the set parameters.

The above embodiments are only used to illustrate the present invention, not intended to limit the scope thereof. Many modifications of the above embodiments can be made without departing from the spirit of the present invention.

## Claims

1. An automatic solar tracking adjustment/control apparatus of solar generation system, comprising:
a support assembly (1), a support seat (12) being disposed at one end of the support assembly (1);
a carrier platform (21) disposed on the support seat (12) via a two-dimensionally movable pivotal rotational assembly (5), at least one solar generation module (2) being disposed on the carrier platform (21) for converting solar energy into electrical energy;
at least one drive assembly (3, 4, 7, 8) disposed between the support assembly (1) and the carrier platform (21), the drive assembly (3, 4, 7, 8) serving to drive the carrier platform (21) according to reference parameters previously stored in a control unit, whereby the carrier platform (21) can be tilted in different directions and different inclination angles around the pivotal rotational assembly (5); and
a detection/correction module (6) disposed on the carrier platform (21) for detecting and obtaining actual parameters including tilting direction and inclination angle of the carrier platform (21) and feeding the actual parameters back to the control unit, the control unit comparing the actual parameters with the previously stored reference parameters to obtain a comparison result, whereby according to the comparison result, the control unit modifies the tilting direction and inclination angle of the carrier platform (21) via the drive assembly (3, 4, 7, 8),
wherein each drive assembly (7, 8) includes a power source (71, 81) and two connection members (73, 74, 83, 84) drivable by the power source (71, 81), each connection member being a cable, wherein the power source (31, 41, 71, 81) drives a drive member (72, 82),
**characterized in that** first and second drive sections (721, 722, 821, 822) are disposed on the drive member (72, 82), the first andseconddrivesections (721, 722, 821, 822) being synchronously operable, the first ends of the two connection members (73, 74, 83, 84) being respectively wound on the first and second drive sections (721, 722, 821, 822) in reverse directions, such that when the first drive section (721, 821) forward drives the first connection member (73, 83) to wind up the same, then the second drive section (722, 822) simultaneously unwinds the second connection member (74, 84), and vice versa, wherein the second ends of the two connection members (73, 74, 83, 84) are respectively connected to two opposite corner sections of the carrier platform (21) corresponding to two lateral sides of the support assembly (1).

2. The automatic solar tracking adjustment/control apparatus of solar generation system as claimed in claim 1, wherein the detection/correction module (6) at least includes an accelerometer.

3. The automatic solar tracking adjustment/control apparatus of solar generation system as claimed in claim 2, wherein the control unit is disposed in the detection/correction module (6).

4. The automatic solar tracking adjustment/control apparatus of solar generation system as claimed in claim 1, wherein the support assembly (1) at least has a support column (11), the support seat (13) being disposed at one end of the support column (11).

5. The automatic solar tracking adjustment/control apparatus of solar generation system as claimed in claim 1, 2, 3 or 4, wherein the power source (31, 41, 71, 81) is a motor and each connection member (32, 42, 73, 74, 83, 84) is a steel cable and the drive member (72, 82, 311, 411) is a drive wheel connected to the steel cable.

6. The automatic solar tracking adjustment/control apparatus of solar generation system as claimed in claim 1, 2, 3 or 4, wherein each drive assembly (3, 4, 7, 8) further includes at least one idling member (33, 331, 43, 431, 731, 741, 831, 841) and each connection member (32, 42, 73, 74, 83, 84) passes through an edge of the idling member (33, 331, 43, 431, 731, 741, 831, 841) and is reversely wound.

7. The automatic solar tracking adjustment/control apparatus of solar generation system as claimed in claim 1, 2, 3 or 4, wherein each connection member (32, 42, 73, 74, 83, 84) is serially connected with at least one elastic member (34, 341, 44, 441, 731a, 741a, 831a, 841a).

8. The automatic solar tracking adjustment/control apparatus of solar generation system as claimed in claim 7, wherein the elastic member (34, 341, 44, 441, 731a, 741a, 831a, 841a) is disposed at a section of the carrier platform (21), which section is connected to the connection member (32, 42, 73, 74, 83, 84).

9. The automatic solar tracking adjustment/control apparatus of solar generation system as claimed in claim 1, 2, 3 or 4, wherein eachoftheconnectionmembers (32, 42, 73, 74, 83, 84) is connected to an elastic adjustment assembly (73a, 74a, 83a, 84a).

10. The automatic solar tracking adjustment/control apparatus of solar generation system as claimed in claim 9, wherein the elastic adjustment assembly (73a, 74a, 83a, 84a) includes at least one elastic member (34, 341, 44, 441, 731a, 741a, 831a, 841a) fitted on a connection member (32, 42, 73, 74, 83, 84).

11. The automatic solar tracking adjustment/control apparatus of solar generation system as claimed in claim 10, wherein a first end of the elastic member (34, 341, 44, 441, 731a, 741a, 831a, 841a) is connected to an external fixed article, while a second end of the elastic member (34, 341, 44, 441, 731a, 741a, 831a, 841a) is provided with a fitting member connected to a middle section of the connection member (32, 42, 73, 74, 83, 84).

12. The automatic solar tracking adjustment/control apparatus of solar generation system as claimed in claim 11, wherein the fitting member is a pulley.

13. The automatic solar tracking adjustment/control apparatus of solar generation system as claimed in claim 12, wherein the two drive sections (721, 722, 821, 822) are two annular grooves disposed on the drive wheel, the two connection members (32, 42, 73, 74, 83, 84) being respectively wound on the annular grooves in reverse directions.

14. The automatic solar tracking adjustment/control apparatus of solar generation system as claimed in claim 1, 2, 3 or 4, wherein the carrier platform (21) is polygonal and two ends of the connection members (32, 42, 73, 74, 83, 84) are respectively connected to two opposite corner sections of the carrier platform (21).

15. The automatic solar tracking adjustment/control apparatus of solar generation system as claimed in claim 1, 2, 3, or 4, wherein the pivotal rotational assembly (5) includes a pivot seat (51), a first shaft rod (52) and a second shaft rod (53), the first and second shaft rods (52, 53) passing through the pivot seat (51) and intersecting each other, two ends of the first shaft rod (52) being disposed on the support seat (13), while two ends of the second shaft rod (53) being disposed on the carrier platform (21).

16. The automatic solar tracking adjustment/control apparatus of solar generation system as claimed in claim 15, wherein the two ends of the first shaft rod (52) are pivotally connected to the support seat (13) via bearings (521, 531) and the two ends of the second shaft rod (53) are connected to the carrier platform (21) via bearings (521, 531).

## Patentansprüche

1. Automatische Anpassungs-/Steuervorrichtung zur Sonnennachführung eines Solarstromerzeugungssystems, mit:
einer Stütze (1), wobei eine Stützaufnahme (12) an einem Ende der Stütze (1) angeordnet ist;
eine Trägerplattform (21), die auf der Stützaufnahme (12) mittels einer zweidimensional beweglichen Drehpunkt-Rotationseinheit (5) angeordnet ist;
mindestens einem Solarerzeugungsmodul (2), das auf der Trägerplattform (21) zum Umwandeln von Sonnenenergie in elektrische Energie angeordnet ist;
mindestens einem Antriebsaggregat (3, 4, 7, 8) zwischen der Stütze (1) und der Trägerplattform (21), wobei das Antriebsaggregat (3, 4, 7, 8) dazu dient, die Trägerplattform (21) anzutreiben, gemäß Bezugsparametern, die vorher in einer Steuereinheit gelagert wurden, wodurch die Trägerplattform (21) in verschiedene Richtungen und verschiedene Neigungswinkel rund um die Drehpunkt-Rotationseinheit (5) geneigt werden kann; und
einem Erkennungs-/Korrekturmodul (6) auf der Trägerplattform (21) zum Erfassen und Erhalten tatsächlicher Parameter einschließlich Kipprichtung und Neigungswinkel der Trägerplattform (21) und Liefern der tatsächlichen Parameter zurück an die Steuereinheit, wobei die Steuereinheit die tatsächlichen Parameter mit den vorher gespeicherten Bezugsparametern vergleicht, um ein Vergleichsergebnis zu erhalten, wodurch je nach dem Vergleichsergebnis die Steuereinheit Kipprichtung und Neigungswinkel der Trägerplattform (21) mittels des Antriebsaggregats (3, 4, 7, 8) ändert,
wobei jedes Antriebsaggregat (7, 8) eine Energiequelle (71, 81) umfasst und zwei Verbindungselemente (73, 74, 83, 84), die durch die Energiequelle (71, 81) antreibbar sind, wobei jedes Verbindungselement ein Kabel ist, wobei die Energiequelle (31, 41, 71, 81) ein Antriebselement (72,82) antreibt,
**gekennzeichnet dadurch, dass** erste und zweite Antriebsabschnitte (721, 722, 821, 822) auf dem Antriebselement (72,82) angeordnet sind, wobei die ersten und zweiten Antriebsabschnitte (721, 722, 821, 822) synchron betätigbar sind, wobei die ersten Enden der beiden Verbindungselemente (73, 74, 83, 84) in entgegengesetzte Richtungen auf die ersten bzw. zweiten Antriebsabschnitte (721, 722, 821, 822) gewickelt sind, so dass, wenn der erste Antriebsabschnitt (721, 821) das erste Verbindungselement (73,83) vorwärts treibt, um dieses aufzuwickeln, dann wickelt der zweite Antriebsabschnitt (722, 822) gleichzeitig das zweite Verbindungselement (74, 84) ab, und umgekehrt, wobei die zweiten Enden der beiden Verbindungselemente (73, 74, 83, 84) jeweils mit zwei gegenüberliegenden Eckabschnitten der Trägerplattform (21) verbunden sind, entsprechend zwei Seitenwänden der Stütze (1).

2. Automatische Anpassungs-/Steuervorrichtung zur Sonnennachführung eines Solarstromerzeugungssystems nach Anspruch 1, wobei das Erkennungs-/Korrekturmodul (6) mindestens einen Beschleunigungsmesser umfasst.

3. Automatische Anpassungs-/Steuervorrichtung zur Sonnennachführung eines Solarstromerzeugungssystems nach Anspruch 2, wobei die Steuereinheit in dem Erkennungs-/Korrekturmodul (6) angeordnet ist.

4. Automatische Anpassungs-/Steuervorrichtung zur Sonnennachführung eines Solarstromerzeugungssystems nach Anspruch 1, wobei die Stütze (1) mindestens eine Stützsäule (11) aufweist, wobei die Stützaufnahme (13) an einem Ende der Stützsäule (11) angeordnet ist.

5. Automatische Anpassungs-/Steuervorrichtung zur Sonnennachführung eines Solarstromerzeugungssystems nach Anspruch 1, 2, 3 oder 4, wobei die Energiequelle (31, 41, 71, 81) ein Motor ist und jedes Verbindungselement (32, 42, 73, 74, 83, 84) ein Stahlkabel ist und das Antriebselement (72, 82, 311, 411) ein Antriebsrad ist, das mit dem Stahlkabel verbunden ist.

6. Automatische Anpassungs-/Steuervorrichtung zur Sonnennachführung eines Solarstromerzeugungssystems nach Anspruch 1, 2, 3 oder 4, wobei jede Antriebsaggregat (3, 4, 7, 8) außerdem mindestens ein freilaufendes Element (33, 331, 43, 431, 731, 741, 831, 841) umfasst und jedes Verbindungselement (32, 42, 73, 74, 83, 84) eine Kante des freilaufenden Elements (33, 331, 43, 431, 731, 741, 831, 841) durchquert und umgekehrt aufgewickelt wird.

7. Automatische Anpassungs-/Steuervorrichtung zur Sonnennachführung eines Solarstromerzeugungssystems nach Anspruch 1, 2, 3 oder 4, wobei jedes Verbindungselement (32, 42, 73, 74, 83, 84) seriell mit mindestens einem elastischen Element (34, 341, 44, 441, 731a, 741a, 831a, 841a) verbunden ist.

8. Automatische Anpassungs-/Steuervorrichtung zur Sonnennachführung eines Solarstromerzeugungssystems nach Anspruch 7, wobei das elastische Element (34, 341, 44, 441, 731a, 741a, 831a, 841a) an einem Abschnitt der Trägerplattform (21) angeordnet ist, der mit dem Verbindungselement (32, 42, 73, 74, 83, 84) verbunden ist.

9. Automatische Anpassungs-/Steuervorrichtung zur Sonnennachführung eines Solarstromerzeugungssystems nach Anspruch 1, 2, 3 oder 4, wobei jedes der Verbindungselemente (32, 42, 73, 74, 83, 84) mit einer elastischen Anpassungseinheit verbunden ist (73a, 74a, 83a, 84a).

10. Automatische Anpassungs-/Steuervorrichtung zur Sonnennachführung eines Solarstromerzeugungssystems nach Anspruch 9, wobei die elastische Anpassungseinheit (73a, 74a, 83a, 84a) mindestens ein elastisches Element (34, 341, 44, 441, 731a, 741a, 831a, 841a) umfasst, das auf ein Verbindungselement (32, 42, 73, 74, 83, 84) montiert ist.

11. Automatische Anpassungs-/Steuervorrichtung zur Sonnennachführung eines Solarstromerzeugungssystems nach Anspruch 10, wobei ein erstes Ende des elastischen Elements (34, 341, 44, 441, 731a, 741a, 831a, 841a) mit einem äußeren festen Element verbunden ist, während ein zweites Ende des elastischen Elements (34, 341, 44, 441, 731a, 741a, 831a, 841a) ein Passelement aufweist, das mit einem Mittenabschnitt des Verbindungselements (32, 42, 73, 74, 83, 84) verbunden ist.

12. Automatische Anpassungs-/Steuervorrichtung zur Sonnennachführung eines Solarstromerzeugungssystems nach Anspruch 11, wobei das Passelement eine Riemenscheibe ist.

13. Automatische Anpassungs-/Steuervorrichtung zur Sonnennachführung eines Solarstromerzeugungssystems nach Anspruch 12, wobei die beiden Antriebsabschnitte (721, 722, 821, 822) zwei ringförmige Nuten sind, die auf dem Antriebsrad angeordnet sind, wobei die beiden Verbindungselemente (32, 42, 73, 74, 83, 84) jeweils in entgegengesetzte Richtungen auf die ringförmigen Nuten gewickelt sind.

14. Automatische Anpassungs-/Steuervorrichtung zur Sonnennachführung eines Solarstromerzeugungssystems nach Anspruch 1, 2, 3 oder 4, wobei die Trägerplattform (21) mehreckig ist und zwei Enden der Verbindungselemente (32, 42, 73, 74, 83, 84) jeweils mit zwei gegenüberliegenden Eckabschnitten der Trägerplattform (21) verbunden sind.

15. Automatische Anpassungs-/Steuervorrichtung zur Sonnennachführung eines Solarstromerzeugungssystems nach Anspruch 1, 2, 3, oder 4, wobei die Drehpunkt-Rotationseinheit (5) eine Zapfenaufnahme (51) umfasst, eine erste Wellenstange (52) und eine zweite Wellenstange (53), wobei die erste und die zweite Wellenstange (52, 53) die Zapfenaufnahme (51) durchqueren und einander kreuzen, wobei zwei Enden der ersten Wellenstange (52) auf der Stützaufnahme (13) angeordnet sind, während zwei Enden der zweiten Wellenstange (53) auf der Trägerplattform (21) angeordnet sind.

16. Automatische Anpassungs-/Steuervorrichtung zur Sonnennachführung eines Solarstromerzeugungssystems nach Anspruch 15, wobei die beiden Enden der ersten Wellenstange (52) mit der Stützaufnahme (13) durch Lager (521, 531) schwenkbar sind ist und die beiden Enden der zweiten Wellenstange (53) mit der Trägerplattform (21) durch Lager (521, 531) verbunden sind.

## Revendications

1. Appareil d'ajustement/contrôle de suivi solaire automatique de système de génération solaire, comprenant :
un ensemble support (1), une base de support (12) étant disposée à une extrémité de l'ensemble support (1) ;
une plate-forme porteuse (21) disposée sur la base de support (12) par l'intermédiaire d'un ensemble rotatif pivotant (5) mobile dans deux dimensions, au moins un module de génération solaire (2) étant disposé sur la plate-forme porteuse (21) pour convertir de l'énergie solaire en énergie électrique ;
au moins un ensemble d'entraînement (3, 4, 7, 8) disposé entre l'ensemble support (1) et la plate-forme porteuse (21), l'ensemble d'entraînement (3, 4, 7, 8) servant à entraîner la plate-forme porteuse (21) en fonction de paramètres de référence précédemment stockés dans une unité de commande, la plate-forme porteuse (21) pouvant être inclinée dans différentes directions et différents angles d'inclinaison autour de l'ensemble rotatif pivotant (5) ; et
un module de détection/correction (6) disposé sur la plate-forme porteuse (21) pour détecter et obtenir des paramètres réels comprenant la direction d'inclinaison et l'angle d'inclinaison de la plate-forme porteuse (21) et retourner les paramètres réels à l'unité de commande, l'unité de commandes comparant les paramètres réels aux paramètres de référence précédemment stockés pour obtenir un résultat de comparaison, ce par quoi, selon le résultat de comparaison, l'unité de commande modifie la direction d'inclinaison et l'angle d'inclinaison de la plate-forme porteuse (21) par l'intermédiaire de l'ensemble d'entraînement (3, 4, 7, 8),
chaque ensemble d'entraînement (7, 8) comprenant une source motrice (71, 81) et deux éléments de liaison (73, 74, 83, 84) aptes à être entraînés par la source motrice (71, 81), chaque élément de liaison étant un câble, la source motrice (31, 41, 71, 81) entraînant un élément d'entraînement (72, 82),
**caractérisé par le fait que** des première et seconde sections d'entraînement (721, 722, 821, 822) sont disposées sur l'élément d'entraînement (72, 82), les première et seconde sections d'entraînement (721, 722, 821, 822) étant actionnables de façon synchrone, les premières extrémités des deux éléments de liaison (73, 74, 83, 84) étant respectivement enroulées sur les première et seconde sections d'entraînement (721, 722, 821, 822) dans des directions opposées, de telle sorte que lorsque la première section d'entraînement (721, 821) entraîne vers l'avant le premier élément de liaison (73, 83) pour l'enrouler, alors la seconde section d'entraînement (722, 822) déroule simultanément le second élément de liaison (74, 84), et inversement, les secondes extrémités des deux éléments de liaison (73, 74, 83, 84) étant respectivement reliées à deux sections de coin opposées de la plate-forme porteuse (21) correspondant à deux côtés latéraux de l'ensemble support (1).

2. Appareil d'ajustement/contrôle de suivi solaire automatique de système de génération solaire selon la revendication 1, dans lequel le module de détection/correction (6) au moins comprend un accéléromètre.

3. Appareil d'ajustement/contrôle de suivi solaire automatique de système de génération solaire selon la revendication 2, dans lequel l'unité de commande est disposée dans le module de détection/correction (6).

4. Appareil d'ajustement/contrôle de suivi solaire automatique de système de génération solaire selon la revendication 1, dans lequel l'ensemble support (1) au moins comprend une colonne de support (11), la base de support (13) étant disposée à une extrémité de la colonne de support (11).

5. Appareil d'ajustement/contrôle de suivi solaire automatique de système de génération solaire selon la revendication 1, 2, 3 ou 4, dans lequel la source motrice (31, 41, 71, 81) est un moteur et chaque élément de liaison (32, 42, 73, 74, 83, 84) est un câble d'acier et l'élément d'entraînement (72, 82, 311, 411) est une roue d'entraînement reliée au câble d'acier.

6. Appareil d'ajustement/contrôle de suivi solaire automatique de système de génération solaire selon la revendication 1, 2, 3 ou 4, dans lequel chaque ensemble d'entraînement (3, 4, 7, 8) comprend en outre au moins un élément monté fou (33, 331, 43, 431, 731, 741, 831, 841) et chaque élément de liaison (32, 42, 73, 74, 83, 84) passe par un bord de l'élément monté fou (33, 331, 43, 431, 731, 741, 831, 841) et est enroulé de façon inverse.

7. Appareil d'ajustement/contrôle de suivi solaire automatique de système de génération solaire selon la revendication 1, 2, 3 ou 4, dans lequel chaque élément de liaison (32, 42, 73, 74, 83, 84) est relié en série à au moins un élément élastique (34, 341, 44, 441, 731a, 741a, 831a, 841a).

8. Appareil d'ajustement/contrôle de suivi solaire automatique de système de génération solaire selon la revendication 7, dans lequel l'élément élastique (34, 341, 44, 441, 731a, 741a, 831a, 841a) est disposé à une section de la plate-forme porteuse (21), laquelle section est reliée à l'élément de liaison (32, 42, 73, 74, 83, 84).

9. Appareil d'ajustement/contrôle de suivi solaire automatique de système de génération solaire selon la revendication 1, 2, 3 ou 4, dans lequel chacun des éléments de liaison (32, 42, 73, 74, 83, 84) est relié à un ensemble d'ajustement élastique (73a, 74a, 83a, 84a).

10. Appareil d'ajustement/contrôle de suivi solaire automatique de système de génération solaire selon la revendication 9, dans lequel l'ensemble d'ajustement élastique (73a, 74a, 83a, 84a) comprend au moins un élément élastique (34, 341, 44, 441, 731a, 741a, 831a, 841a) monté sur un élément de liaison (32, 42, 73, 74, 83, 84).

11. Appareil d'ajustement/contrôle de suivi solaire automatique de système de génération solaire selon la revendication 10, dans lequel une première extrémité de l'élément élastique (34, 341, 44, 441, 731a, 741a, 831a, 841a) est reliée à un article fixe externe, tandis qu'une seconde extrémité de l'élément élastique (34, 341, 44, 441, 731a, 741a, 831a, 841a) comporte un élément de montage relié à une section centrale de l'élément de liaison (32, 42, 73, 74, 83, 84).

12. Appareil d'ajustement/contrôle de suivi solaire automatique de système de génération solaire selon la revendication 11, dans lequel l'élément de montage est une poulie.

13. Appareil d'ajustement/contrôle de suivi solaire automatique de système de génération solaire selon la revendication 12, dans lequel les deux sections d'entraînement (721, 722, 821, 822) sont deux gorges annulaires disposées sur la roue d'entraînement, les deux éléments de liaison (32, 42, 73, 74, 83, 84) étant respectivement enroulés sur les gorges annulaires dans des directions opposées.

14. Appareil d'ajustement/contrôle de suivi solaire automatique de système de génération solaire selon la revendication 1, 2, 3 ou 4, dans lequel la plate-forme porteuse (21) est polygonale et deux extrémités des éléments de liaison (32, 42, 73, 74, 83, 84) sont respectivement reliées à deux sections de coin opposées de la plate-forme porteuse (21).

15. Appareil d'ajustement/contrôle de suivi solaire automatique de système de génération solaire selon la revendication 1, 2, 3 ou 4, dans lequel l'ensemble rotatif pivotant (5) comprend un siège de pivot (51), un premier arbre (52) et un second arbre (53), les premier et second arbres (52, 53) passant à travers le siège de pivot (51) et se croisant mutuellement, deux extrémités du premier arbre (52) étant disposées sur la base de support (13), tandis que deux extrémités du second arbre (53) étant disposées sur la plate-forme porteuse (21).

16. Appareil d'ajustement/contrôle de suivi solaire automatique de système de génération solaire selon la revendication 15, dans lequel les deux extrémités du premier arbre (52) sont reliées de façon pivotante à la base de support (13) par l'intermédiaire de paliers (521, 531) et les deux extrémités du second arbre (53) sont reliées à la plate-forme porteuse (21) par l'intermédiaire de paliers (521, 531).
